Europäisches Patentamt

European Patent Office

Office européen des brevets

(11) Publication number: **0 268 378**
**A2**

# (12) EUROPEAN PATENT APPLICATION

(21) Application number: **87309207.6**

(22) Date of filing: **19.10.87**

(30) Priority: **20.10.86 US 920973**

(43) Date of publication of application:
**25.05.88 Bulletin 88/21**

(84) Designated Contracting States:
**AT BE CH DE ES FR GB GR IT LI NL SE**

(51) Int. Cl.⁴: **G01D 7/12**

(71) Applicant: **Chen, Shih-Chung**
**No. 55, Ming Der Rd.**
**Wu Gu Taipei Hsien(TW)**

(72) Inventor: **Chen, Shih-Chung**
**No. 55, Ming Der Rd.**
**Wu Gu Taipei Hsien(TW)**

(74) Representative: **Prentice, Raymond Roy**
**R.R. Prentice & Co. 34 Tavistock Street**
**London WC2E 7PB(GB)**

(54) **A phonic meter for measuring current/force/resistance.**

(57) A phonic meter which can convert its analog measurement signal into digital signal via an A/D converter (11). Said digital signal will be sent not only to a phone processor (30) to produce corresponding phonic measurement reading, but also to a decoder (12) to drive a display (13) to show the corresponding measurement reading. The present invention offers a phonic meter whose measurement reading can be shown by phone as well as by the display.

FIG3A

## A PHONIC METER FOR MEASURING CURRENT/ FORCE/RESISTANCE

The invention relates to a kind of phonic meter for measuring current/force/resistance.

The present invention offers a novelty meter whose reading can be identified not only by the display, but also by the phone of the phone processor. A preferred embodiment in accordance with ideas of this invention is described as follows:

The analog values measured by the traditional meter will be converted into digital signal through an analog-to-digital converter (thereafter called A/D converter). Said digital signal will then be sent first to a phone processor via a register to produce the corresponding phone, and also to a decoder to drive the display to show the corresponding reading.

Therefore the preferred embodiment of phonic meter for electricity under present invention can utter the measured values as well as show them on the display.

When electronic maintenance engineers, equipped with traditional meters, do troubleshooting, they must locate the test points of the circuit as well as check the reading of their meter; the troubleshooting procedure is timeconsuming and inconvenient. And during troubleshooting for the complicated circuit, it may even result in more errors, because it is difficult for maintenance engineers to take care test points locating as well as measurement reading. Yet if maintenance engineers can hear the measurement reading directly, it will free them from checking the meter from time to time, and also save time the prevent maintenance engineers from reading errors, so as to provide convenience and reliability during circuit troubleshooting. Up to new, there is no such phonic digiyal meter invented.

To solve the existing problems, the present invention offers a novelty meter to meet above requirements. The present invention is featured of multimeter reading, not only by traditional display, but also by the phone of phone processor. Therefore, the maintenance engineers can identify the reading clearly. The present invention is a breakthrough in consideration of its ideas, function, and operation; and it does offer an innovatory, convenient and practical meter.

Fig. 1 is a flow chart of the preferred embodiment of the present invention.

Fig. 2 is a block diagram of the preferred embodiment of the present invention.

Fig. 3A/3B is a circuit diagram of the present invention.

Fig. 4A/4B is another circuit diagrams of this invention, even including the complete related accessories such as the exact probe connecting points, ... etc.

Fig. 5a is an equivalent circuit diagram of Block D in Fig. 4.

Fig. 5b is a function illustrating diagram of Block E in Fig. 4.

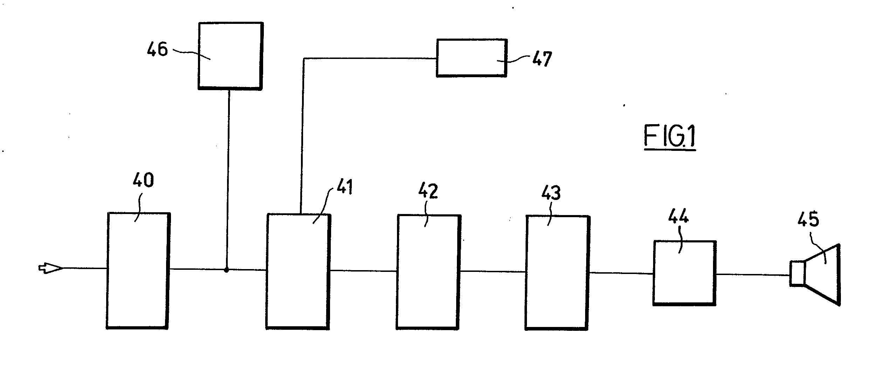

As shown in Fig. 1, the preferred embodiment of the phone meter incorporates both measurement reading means by phone and by digital display.

An analog measurement signal from the meter is sent, via an attenuator 40, to an A/D converter 41 which is followed by a decoder 42. The decoded converted digital signal is passed to a phone processor 43 which generates a corresponding digital phone signal which, after amplification by an amplifier 44, will drive a speaker 45. The analog measurement signal can also drive an analog display 46 directly to show the corresponding analog reading and/or the BCD digital signal converted by the converter 41 can drive a digital display 47 to show the corresponding digital reading.

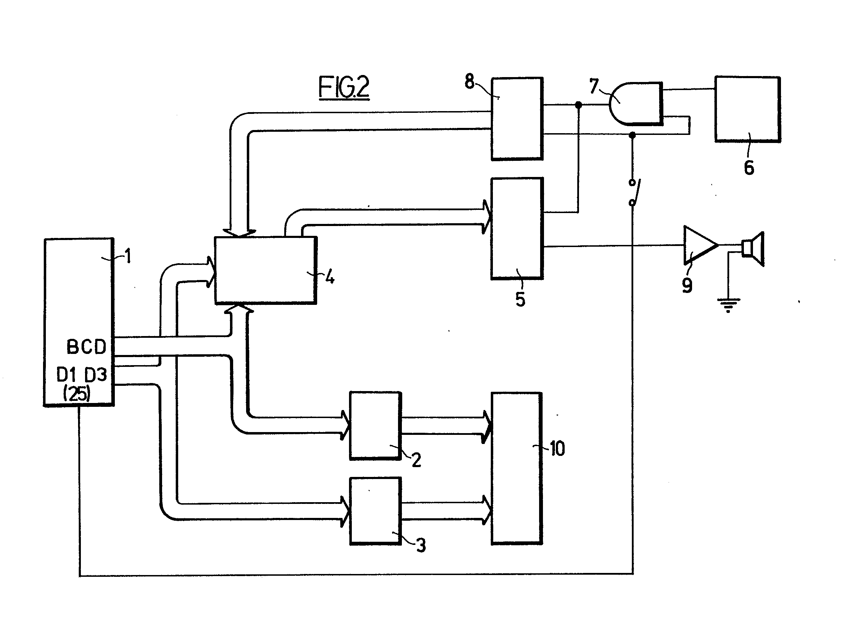

In Fig. 2, the analog signal measured by the meter will be converted via an A/D converter into a digital signal which has two kinds of outputs: one is a BCD signal represented by B1, B2, B4 and B8 while the other is a digital scan signal represented by D5 - D1. The BCD signal is sent not only to a decoder 2 to drive a display 10, so as to show the corresponding digital reading, but also to a phone processor 5 via a register 4 to process the phonic digital signal output which will be sent to a filter amplify circuit 9 to generate a corresponding phonic reading.

The digital scan signal is sent to a driver 3, to drive said display 10, and also controls the BCD data storage of said register 4. The data input of said register 4 is controlled by a counter 8, and the start or the end of the phonic reading is controlled by the output of an AND GATE 7. The timing pulse generated by a timer 6 and the pin 25 of said A/D converter 1 are two inputs of said AND GATE 7.

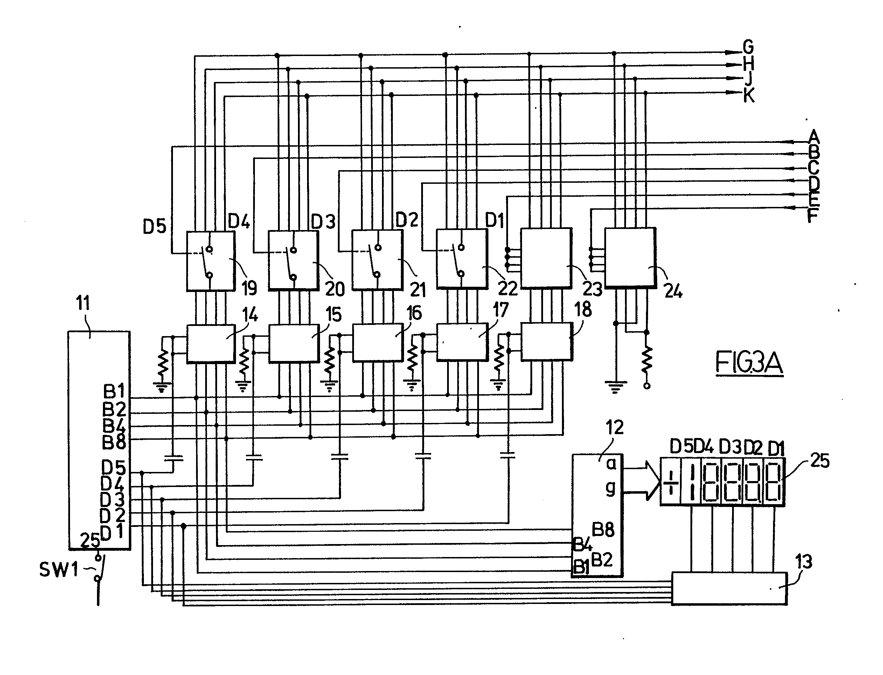

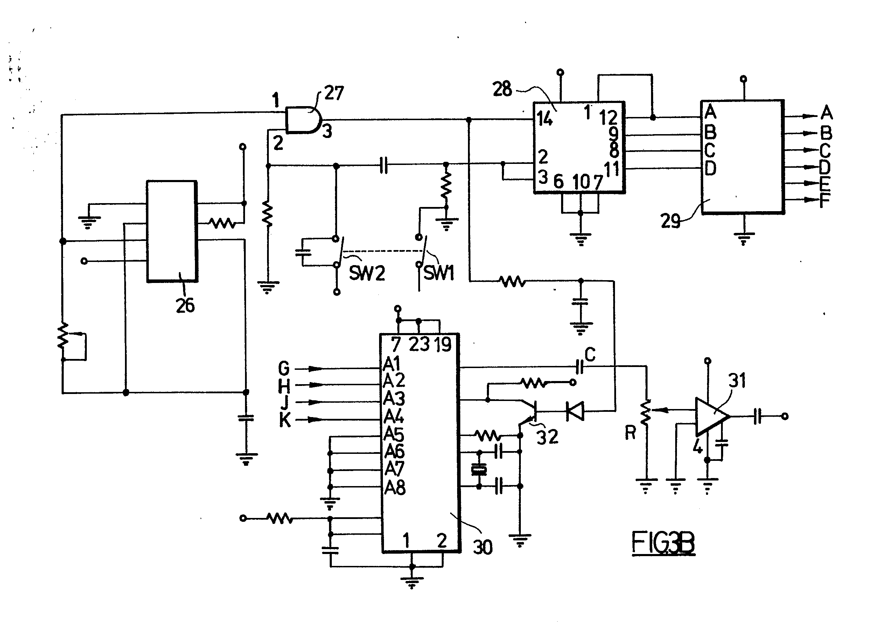

The circuit diagram designed according to the block diagram in Fig. 2 is illustrated in Fig. 3A/3B as: the analog signal measured by the probe of said meter will be converted via a 4-1/2 digit A/D converter 11 into digital signal which includes a BCD signal (represented by B1, B2, B4, and B8) and a digital scan signal (represented by D5 - D1). Said digital scan signal has two functions: one is to control the data storage of the registers 14-18, and the other is to control the showing of the display 25.

Said BCD signal represents the measured digital data and will be sent to said register 14-18 as well as to a BCD-to-7-segment decoder 12 to drive said display 25 so as to show the measurement readings.

While a timer 26, an unsteady multivibrator, will generate a square wave of appropriate frequency to serve as the timing pulse which will then be sent through AND GATE 27 whose output wave form will be determined by the output of pin 25 (RUN/HOLD) of said A/D converter 11. And a switch SW1/SW2 of double poles and single throw is installed to control the start or the end of the output of phonic signal, and also the output status of a counter 28. When said switch SW1/SW2 is "OFF", the output of said AND GATE 27 remains low; when said switch SW1/SW2 is "ON", said AND GATE 27 is enabled to produce output wave thereof to achieve the control requirement.

The output of said AND GATE 27 is then be sent to pin 14 of a decimal counter 28 whose pin 12 has output connected with the input of pin 1 to perform BCD counting.

Said BCD decimal counter 28 will then be connected with a ABCD-to-decimal decoder 29 whose output pins (pin 2 - pin 7) will respectively control the switch circuits 19-24. If the inputs of said switch circuits 19-24 are high, said switch circuits 19-24 are "ON". On the contrary, if the inputs of said switch circuits 19-24 are low, said switch circuits 19-24 are "OFF". Besides, when said switch circuits 19-24 are "ON", the BCD data of the registers 14-18 can be sent to the phone processor 30. Among above six switch circuit 19-24, switch circuit 24 is to control the decimal point. The output pins A, B, C, D, E, F, of said decoder 29 respectively control said switch circuits 19-24, so as to show the measured reading valid up to one digit after the decimal point.

The output pulse of said AND GATE 27 will be sent via a transistor 32 to said phone processor 30 which will then generate the corresponding phonic digital signal to be sent to a RC filter circuit, so as to convert the digital phone signal into analog phone signal which will then be amplified by an amplifier 31 to drive a speaker to send out corresponding measurement reading phone.

When the meter of this invention is applied to test any outside circuit, the measured analog value will be converted via an A/D converter into digital signal to control the storage of the register. While the BCD signal of said digital signal will be sent first to the register controlled by the decimal counter, then to the phone processor to produce corresponding phone.

According to flow chart shown in Fig. and above descriptions, the embodiments of the present invention can be: a simplified phonic meter; or based on designs mentioned above, a phonic meter with digital display by sending BCD signal to a decoder to generate the output signal to drive a digital display to show the corresponding measured value; or a phonic meter with analog display; or a phonic meter with other appropriate display means.

Above said circuit is only one preferred embodiment of the present invention to illustrate and also to prove that this invention can be executed. Yet is should not confine the present invention to said preferred embodiment. Any other embodiment, with the modifications to said preferred embodiment, in accordance with ideas of the present invention, should also be included in the claims of the present invention.

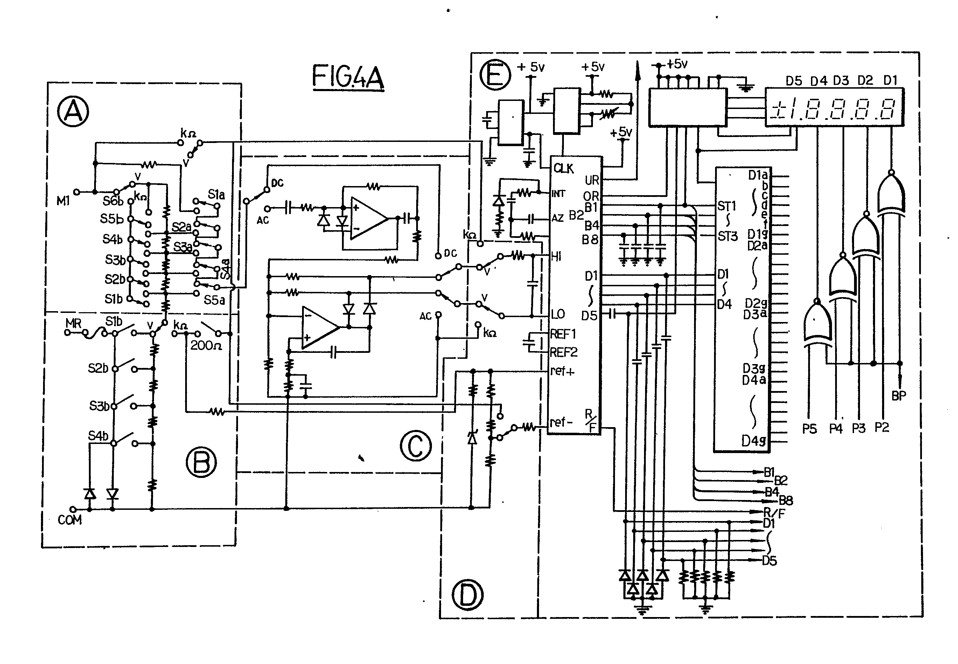

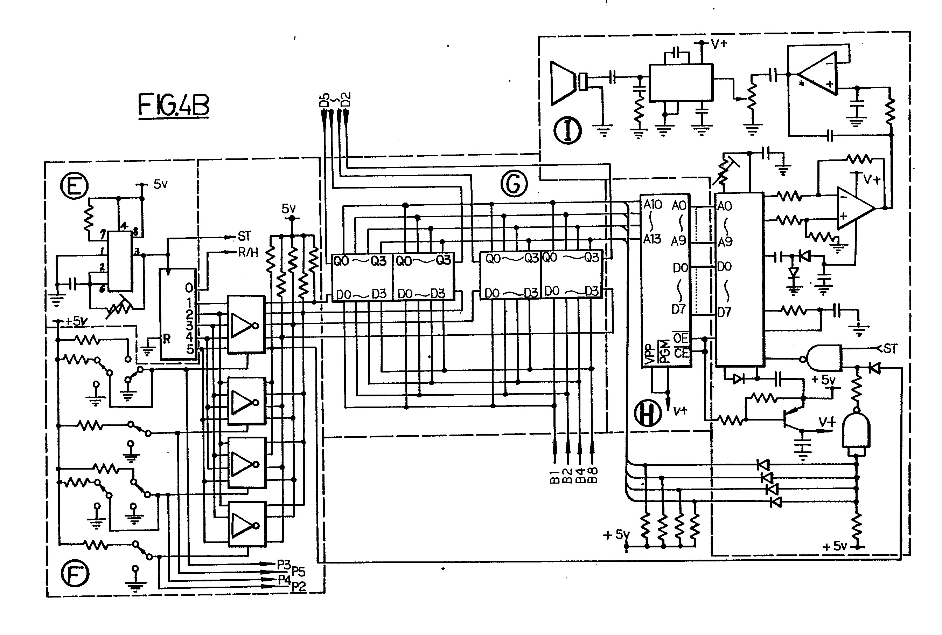

Fig. 4A/4B is another preferred embodiment of this invention to illustrate as follows:

Block A:

When the multimeter is selected for the function "V" or "K ", Block A will be activated. The main function of Block A is to maintain the output voltage within the 200 full scale, no matter where the selected range switch is set.

Block B:

Block B works as the shunt of the current; its main function is to send the measured current through the shunt resistor to generate Voltage Drop based on the OHM's rule of $E = IxR$. The shunted current will then be sent to the A/D converter.

Block C:

Block C is a AC-to-DC RMS (root-mean-square) converter whose main function is to convert effective voltage values of AC into related voltage values of DC.

Block D:

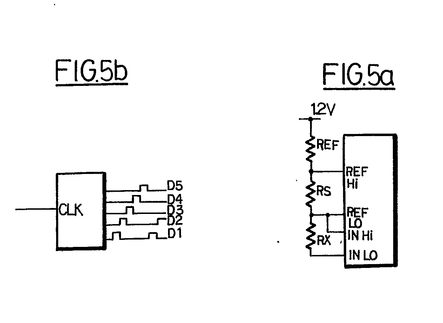

Referring to Fig. 5a, Block D is the selection circuit of "K" function. The display will be 10000 while RS = RX, and therefore the display value will be RX/RS.

Block E:

The main function of Block E is to generate the signal shown in Fig. 5b.

Block F:

Block F is the major function portion of this invention to insert the decimal point.

A tri-state buffer serves as a range switch. When the selection switch is set at different position, the signal sequence from said Block E will be selected to the buffers to put the position of decimal point into the correct position for phone reading. While said signal will be also sent to the decimal point selector of said LCD display.

Block G:

The measured digital signal will be stored in the ROM, then the corresponding data will be generated from said measured value as shown in the table below, so as to read different range by phone which will be pre-recorded before released.

| B1 | B2 | B4 | B8 | P | VOICE |
|----|----|----|----|----|-------|
| 0 | 0 | 0 | 0 | 0 | ZERO |
| 1 | 0 | 0 | 0 | 0 | ONE |
| 0 | 1 | 0 | 0 | 0 | TWO |
| 1 | 1 | 0 | 0 | 0 | THREE |
| 0 | 0 | 1 | 0 | 0 | FOUR |
| 1 | 0 | 1 | 0 | 0 | FIVE |
| 0 | 1 | 1 | 0 | 0 | SIX |
| 1 | 1 | 1 | 0 | 0 | SEVEN |
| 0 | 0 | 0 | 1 | 0 | EIGHT |
| 1 | 0 | 0 | 1 | 0 | NINE |
| 0 | 0 | 0 | 0 | 1 | POINT |
| OTHERS | | | | | SILENT |

Block I:

Block I is the phone process unit to select correct phone for data from the ROM, and said phones will be amplified first, then released by a speaker.

From above descriptions, the present invention offers a meter able to show the measurement reading by phone. The analog measurement signal will be converted via an A/D converter into digital signal which will be sent to a register and then to phone processor to produce phone. Besides, said digital signal can also be sent to a decoder to use the output signal to drive a display, so as to display the measurement reading. The embodiment of the present invention can be: a simplified phonic meter, a phonic multimeter, a phonic meter with analog display, a phonic meter with digital display, or a phonic meter with other types of display means. Therefore, the present invention offers an novelty meter of less reading-error and more convenience superior to the traditional meters.

## Claims

1. A phonic meter for measuring current/force/resistance having the measured analog signal converted via an A/D converter (11) into digital signal which will then be sent to a phone processor (30) to produce phonic measurement reading, and also able to incorporate a display (25) to show the measurement reading.

2. A phonic meter according to claim 1 in which the measured analog signal converted via an A/D converter (11) into digital signal which will be sent not only to registers to produce corresponding phonic measurement reading via a phone processor (30), but also to a decoder (12) to drive a digital display (25) to show the corresponding measurement reading.

3. A phonic meter according to claim 1 in which the major circuit structure of said phonic meter including:
an analog-to-digital conversion means (11) to convert input of analog signal into output of digital signal;
a display means (25), composed of a decoder (12) to decode the BCD digital input which will then be sent to said display (25) to show the corresponding measurement reading, and a LED driver to input the digital scan signal from said alalog-to-digital conversion (11) means to drive said display (25) to show the corresponding measurement reading;
a register means (14-18), controlled by said digital scan signal if to store said BCD data in the register whose output connected with a switch (19-24) circuit having a control terminal respectively controlled by output (A, B, C, D, E, F) of a BCD-to-decimal decoder (29) as: when said control terminal is high, said switch circuit is "ON", and said BCD data will be sent to the phone processor (30); otherwise, then said control terminal is low, said BCD data will not be sent to said phone processor (30);
control means for the output of BCD data and for phonic reading, including a timer (26) to generate a square wave with appropriate frequency to serve as timing pulse; and AND GATE circuit (27) to control the start or the end of phonic reading, a decimal counter (28) whose QA output pin connected with its B input pin to work as BCD counting whose output will be sent to a BCD-to-decimal decorder (29) ot generate a decimal counting output;
a phone processing means, in which said BCD data will be sent to a phone processor (30) to generate the output of corresponding digital phonic signal which will then be converted via a filter circuit (9) into analog phonic signal to be amplified by an amplifier (31) to drive a speaker (45) so as to produce corresponding phonic measurement reading.

4. The analog-to-digital conversion means according to claim 3 having two kinds of output signals: one is the BCD signal representing the measurement data, the other is the digital scan signal (D5-D1).

FIG.1

0 268 378

FIG.2

FIG.3A

0 268 378

FIG3B

FIG.4A

0 268 378

FIG.4B

0 268 378

FIG.5a

12V

REF

REF HI

RS

REF LO

RX

IN HI

IN LO

FIG.5b

CLK

D5
D4
D3
D2
D1